Europäisches Patentamt

European Patent Office

Office européen des brevets

(19)

(11) Publication number : **0 348 051 B1**

# EUROPEAN PATENT SPECIFICATION

(12)

(45) Date of publication of patent specification :
07.09.94 Bulletin 94/36

(51) Int. Cl.⁵ : **H05B 35/00**

(21) Application number : **89305531.9**

(22) Date of filing : **01.06.89**

(54) **Output circuit having a voltage level shifting circuit.**

(30) Priority : **24.06.88 JP 156461/88**

(43) Date of publication of application :
**27.12.89 Bulletin 89/52**

(45) Publication of the grant of the patent :
**07.09.94 Bulletin 94/36**

(84) Designated Contracting States :
**DE FR GB**

(56) References cited :
**EP-B- 0 086 671**
**US-A- 4 048 632**

(73) Proprietor : **KABUSHIKI KAISHA TOSHIBA**
**72, Horikawa-cho**
**Saiwai-ku**
**Kawasaki-shi Kanagawa-ken 210 (JP)**

(72) Inventor : **Ueno, Masaji Intellectual Property**
**Division**
**Toshiba Corp. Principal Office, 1-1-1, Shibaura**
**Minato-ku Tokyo (JP)**

(74) Representative : **Freed, Arthur Woolf et al**
**MARKS & CLERK,**
**57-60 Lincoln's Inn Fields**
**London WC2A 3LS (GB)**

EP 0 348 051 B1

## Description

This invention concerns an output circuit for outputting a high voltage output signal by level shifting a low voltage input signal.

Generally, a high voltage driving integrated circuit (IC) is used to drive a light emitting display, such as an electro luminescence (EL) display, a plasma display panel (PDP), since these require a high driving voltage.

In the output circuit of the driving IC, a reduction of the switching time and the power consumption is required in addition to the requirement of the high voltage. Therefore, conventionally, a CMOS circuit has been used to receive an input signal for outputting a low voltage signal. Then, the low voltage signal is level shifted to a high voltage signal by a push-pull type output circuit.

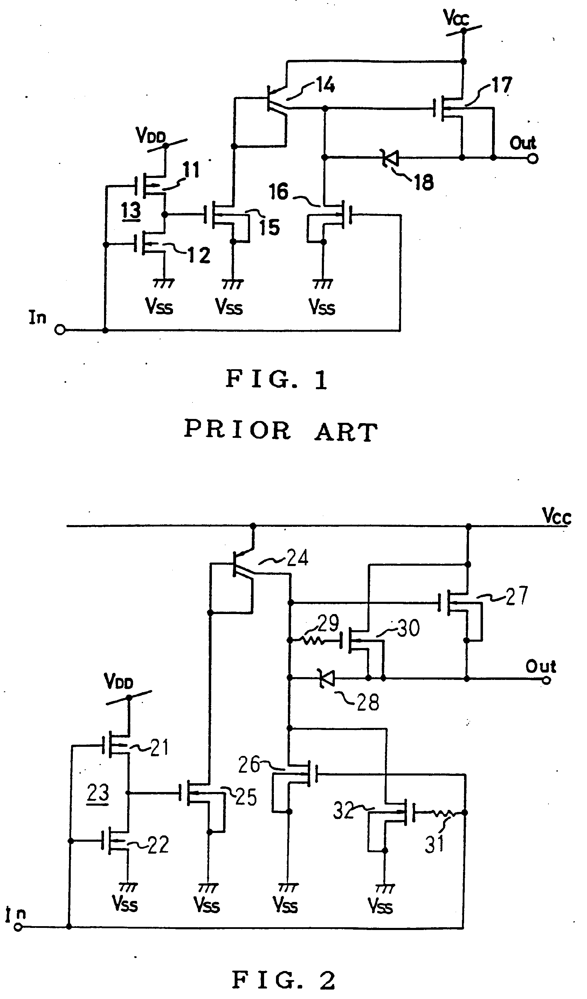

FIG.1 is a circuit diagram of a conventional output circuit used in a driving IC. In the circuit, a CMOS inverter circuit 13, including a P-channel type MOS transistor 11 and an N-channel type MOS transistor 12, is connected between a low power source voltage VDD and a ground VSS. The gate electrodes of the transistors 11 and 12 are connected to an input terminal In.

The gate electrode of an N-channel DMOS (Double diffused MOS) transistor 15 is connected to the the drain electrodes of the MOS transistors 11 and 12, and the source electrode thereof is connected to the ground VSS. An emitter electrode of a multi-collector PNP type bipolar transistor 14 is supplied with a high power source voltage VCC, and one of the collectors and the base electrode are connected to the drain electrode of the MOS transistor 15.

The drain electrode of an N-channel type pull-down MOS transistor 16 is connected to the remaining collector electrode of the multi-collector bipolar transistor 14. The gate electrode of the MOS transistor 16 is supplied with the input signal In, and the source electrode thereof is connected to the ground VSS.

The gate electrode of an N-channel type pull-up MOS transistor 17 is connected to the remaining collector electrode of the bipolar transistor 14, and the drain electrode thereof is supplied with the high power source voltage VCC. The source electrode of the MOS transistor 17 is connected to the output terminal OUT.

The cathode of a Zener diode 18 is connected to the gate electrode of the MOS transistor 17, and the anode of the Zener diode 18 is connected to the source electrode of the MOS transistor 17.

An input signal having a high level and a low level is supplied to the input terminal In, and an output signal is outputted from the output terminal OUT.

The operation is as follows. When the input signal IN is low level, the transistor 11 of the CMOS inverter circuit 13 changes to the ON state, and the transistor 12 changes to the OFF state. Thus, the input signal to the MOS transistor 15 becomes the VDD level, and the transistor 15 changes to the ON state. Therefore, the multi-collector transistor 14 changes to the ON state, and a predetermined voltage drop is developed at the Zener diode 18. The voltage drop at the Zener diode 18 changes the transistor 17 to the ON state. As a result, a parasitic capacitance and a load capacitance (not shown) at the output terminal OUT are charged, and the output signal changes to the high level, namely VCC level.

In the case where the input signal IN is high level, the transistor 12 in the CMOS inverter circuit 13 changes to the ON state and the transistor 11 changes to the OFF state. Thus, the gate potential of the transistor 15 changes to the low level, and the MOS transistor 15 changes to the OFF state. Therefore, the bipolar transistor 14 and the transistor 17 become OFF state. Since the MOS transistor 16 is supplied with the high level input signal IN at the gate electrode thereof, the MOS transistor 16 changes to the ON state. Thus, the parasitic capacitance and the load capacitance at the output terminal OUT are discharged through the MOS transistor 16, and the output signal changes to the low level.

Since the circuit of FIG.1 is used in the driving circuit for a light emitting display, a high driving capability is required for the transistors 16 and 17. For example, in the case where the output circuit is installed in a PDP driving circuit, the load capacitance is about several ten pF, which is relatively small. Thus, a relatively small current is sufficient to charge the capacitance. However, a current of about several ten mA flows at the emission of the light. Therefore, as a result, a high driving capability is necessary for the output transistors 16 and 17.

The transient time from the low level to the high level, namely the rise time $\Delta t$, is expressed as follows.

$$\Delta t = C \cdot V/i \quad (1)$$

wherein C is the capacitance at the output terminal OUT, and V and i are the supplied voltage and the current, respectively.

As apparent from the equation (1), by setting a large driving capability for the pull-up transistor 17, the $\Delta T$ becomes small. A small $\Delta t$ means a large slew rate. The large slew rate causes defects, such as an electromagnetic impediment (EMI), etc. Due to the same reason, there is a similar problem at the transition of the output signal from the high level to the low level.

Therefore, an object of the present invention is to prevent the noise during the transition of the output signal while simultaneously supplying the necessary high driving capability.

To achieve the object, this invention provides an output circuit for outputting at an output terminal an output signal at first and second predetermined levels in response to an input signal alternating in first and second directions between high and low levels at an input terminal, the circuit comprising first power source terminal means for supplying a first power source voltage; second power source terminal means for supplying a second power source voltage which is higher than the first power source voltage; third power source terminal means for supplying a reference voltage; voltage level shift means responsive to a change in level of the input signal in the first direction to provide a level shifted signal having a level substantially equal to the level of the second power source voltage; pull-up circuit means including first transistor means responsive to the signal provided by the voltage level shift means to raise the level of the output signal substantially to the second power source voltage level, and pull-down circuit means responsive to a change in level of the input signal in the second direction to lower the level of the output signal substantially to the reference voltage level, characterised in that the pull-up circuit means includes second transistor means for outputting the second power source voltage to the output terminal, and first delay means for delaying the output from the second transistor means for a predetermined time with respect to the output from the first transistor means.

Other preferred features of the invention will be apparent from the following description and the accompanying claims.

The accompanying drawings, which are incorporated in and constitute a part of the specification, illustrate an embodiment of the invention, and, together with the description, serve to explain the principles of the invention. Referring now to the drawings, like reference characters designate like or corresponding parts throughout the several views. Of the drawings:

FIG. 1 is a circuit diagram of a conventional output circuit,

FIG. 2 is a circuit diagram of a preferred embodiment according to the present invention.

FIG 3 is a circuit diagram of another embodiment according to the present invention.

Referring now to FIG 2, there is illustrated a circuit diagram of a preferred embodiment according to the present invention.

In the preferred embodiment of FIG 2, an input singal In having a high level and a low level is supplied to an input terminal In. A CMOS circuit 23 including a P-channel type MOS transistor 21 and an N-channel type transistor 22 is connected between the first power source voltage VDD and a reference voltage VSS. For example, the first power source voltage **VDD** is 5 volts.

Gate electrodes of the transistors **21** and **22** are connected to the input terminal **IN** to receive the input signal In. The drain electrodes of the transistors **21** and **22** are connected in common, and the respective source electrode is supplied with the reference voltage **VSS** and the first power source voltage Vdd, respectively.

In the present invention, there is provided level shift circuit means responsive to the input signal IN for outputting a level shifted signal having a shifted level substantially equal to a second power source voltage. In the preferred embodiment of **FIG.2**, the level shift circuit means includes an N-channel type **MOS** transistor **25** and a multi-collector type **PNP** bipolar transistor **24**. The gate electrode of the N-channel type **MOS** transistor **25** is connected to the drain electrodes of the **MOS** transistors **21** and **22**. The base electrode and one of the collectors of the bipolar transistor **24** are connected to the drain electrode of the **MOS** transistor **25**. The source electrode of the **MOS** transistor **25** is supplied with the reference voltage **VSS**, and the emitter electrode of the bipolar transistor **24** is supplied with a second power source voltage **VCC**. For example, the second power source voltage **VCC** is 100 volts.

In the present invention, there is provided pull-up circuit means responsive to the level shifted signal for raising the level of the output signal substantially equal to the level of the second power source voltage. In the preferred embodiment of **FIG.2**, the pull-up means includes a first **MOS** transistor **27** and a second **MOS** transistor **30**. The gate electrode of the first transistor **27** is connected to the collector electrode of the bipolar transistor **24**, and the drain electrode thereof is supplied with the second power source voltage **VCC**. The source electrode of the **MOS** transistor **27** is connected to an output terminal **OUT**.

The gate electrode of the second transistor **30** is connected to the collector electrode of the bipolar transistor **24** through a resistor **29**. The resistor **29** is about 80 KΩ. The drain electrode of the transistor **30** is supplied with the second power source voltage **VCC**, and the source electrode is connected to the output terminal **OUT**.

The cathode and the anode of a Zener diode **28** are connected to the gate electrode and the source electrode of the **MOS** transistor **27**, respectively.

In the present invention, there is provided pull down means for lowering the level of the output signal substantially equal to the reference voltage level. In the preferred embodiment of **FIG.2**, the pull-down means includes a third **MOS** transistor **26** and a fourth **MOS** transistor **32**. The source electrodes of the **MOS** transistor **26** and **32** are supplied with the reference voltage **VSS**, and the drain electrodes thereof are connected to the output terminal **OUT** through the Zener diode **28**. The gate electrode of the **MOS** transistor **26** is connected to the input terminal **IN**, and the gate electrode of the **MOS** transistor **32** is connected to the input terminal **In** through a resistor **31**. The resistor **31** is about 80 KΩ.

The operation of the circuit will be explained. When the input signal In changes from the high level "H" to a low level "L",, the **P**-channel type **MOS** transistor **21** in the **CMOS** inverter circuit **23** changes to the ON state. Thus, the **N**-channel type **MOS** transistor **25** changes to the ON state, and the bipolar transistor **24** also changes to the ON state. Therefore, a current which flows the bipolar transistor **24** creates a voltage drop at the Zener diode **28**. When the voltage drop at the Zener diode **28** exceeds the threshold voltages of the **MOS** transistors **27** and **30**, the transistors **27** and **30** become ON state, respectively. For example, the voltage drop at the Zener diode **28** is about 10 volts.

The Zener diode **28** is used as the bias means for the transistors **27** and **30**. By using a constant voltage element as the bias means, there is an advantage. The drain current of a **MOS** transistor is determined as a function of $VG - VTH$). **VG** is the gate to source voltage and **VTH** is the threshold voltage of the **MOS** transistor. Thus, by setting the **VG** constant by the constant voltage element, the drain current can be stabilized.

Furthermore, by setting the **VG** high, e.g. 10 volts, the drain current becomes large. Thus, without increasing the size of the **MOS** transistor, a relatively large driving capability is obtained.

In this circuit, the **MOS** transistor **30** is connected through the resistor **29**. Thus, a delay circuit is constructed by the resistor **29** and the parasitic capacitance (not shown) of the resistor **29** and the gate capacitance of the **MOS** transistor **30**. Therefore, the change of the **MOS** transistor **30** is delayed due to the delay circuit. Thus, initially, the **MOS** transistor **27** changes to the ON state to bring the output signal closer to the second power source voltage Vdd. After a predetermined time, the **MOS** transistor **30** changes to the ON state. Thus, at the static state, the parasitic capacitance and the load capacitance at the output terminal **OUT** are charged by a relatively large current by the transistors **27** and **30**, and the output signal reaches the second power source voltage Vcc.

When the input signal In changes from the low level "L" to a high level "H", the **N**-channel type **MOS** transistor **22** of the **CMOS** inverter circuit **23** changes to the ON state, and the **N**-channel type**MOS** transistor **25** changes to the OFF state. Thus, the bipolar transistor **24** changes to the OFF state.

On the other hand, the **N**-channel type **MOS** transistors **26** and **32** change to the ON state when the input signal In becomes high level. In this circuit, since the **MOS** transistor **32** is connected through the resistor **31**, the change from the OFF state to the ON state is delayed with respect to the change of the transistor **26**, for the same reason as previously explained. Thus, initially, the parasitic capacitance and the load capacitance at the output terminal **OUT** are discharged only through the transistor **26**. After a predetermined time when the output is somewhat lowered, the **MOS** transistor **32** changes to the ON state, and the parasitic capacitance and the load capacitance at the output terminal **OUT** and the parasitic capacitance at the gate electrodes of the transistors **27** and **30** are discharged through the **MOS** transistors **26** and **32**. In this way, the output signal is brought to the reference voltage level **VSS**.

As is apparent from the above description, two pull-up transistors and two pull-down transistors are utilized, and at the beginning of the transition of the output signal, one of the two transistors operates. Thus, the slew rate can be reduced, and the EMI can be prevented. At the static state, the parasitic capacitance and the load capacitance at the output terminal are charged or are discharged by the relatively large driving capacity of the two transistors **27** and **30** or **26** and **32**. Thus, the high current driving capability is satisfied, simultaneously. For example, the sum of the gate widths of the transistors **27** and **30** or **26** and **32** may be equal to the gate width of the **MOS** transistor **17** or **16** in **FIG.1**. Therefore, without increasing the element size, a sufficient current can be achieved at the static state.

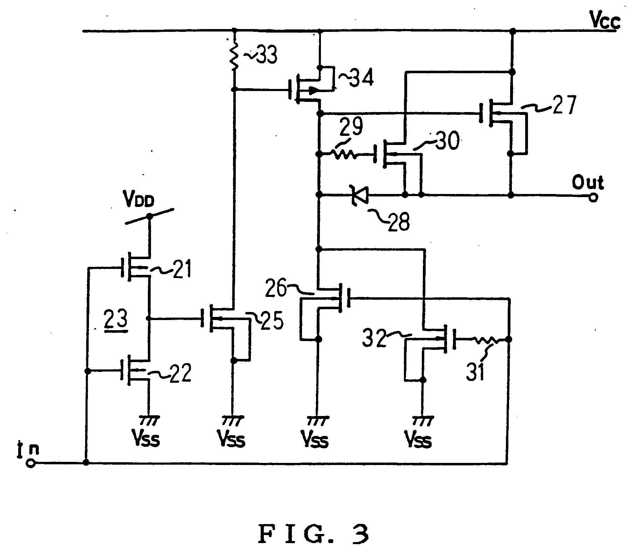

**FIG.3** is a circuit diagram of another embodiment of the present invention. In this embodiment, the level shift means includes a resistor **33** and a high voltage **P**-channel type **MOS** transistor **34** instead of the multi-collector bipolar transistor **24** in the embodiment of **FIG.2**. Namely, the resistor **33** is connected between the source electrode and the gate electrode of the **MOS** transistor **34**. The gate electrode of the **MOS** transistor **34** is connected to the drain electrode of the **MOS** transistor **25**. The source electrode of the **MOS** transistor **34** is supplied with the second power source voltage **VCC**. The drain electrode of the **MOS** transistor **34** is connected to the gate electrode of the **MOS** transistors **27**.

In this circuit, when the input signal In becomes low level "L", the transistor **25** changes to the ON state and a current flows through the resistor **33** to create a predetermined voltage drop. Due to the voltage drop at the resistor **33**, the MOS transistor **34** changes to the ON state, and the pull-up operation of the output signal starts.

**Claims**

1. An output circuit for outputting at an output terminal an output signal (OUT) at first and second predetermined levels (VCC,VSS) in response to an input signal (IN) alternating in first and second directions between high and low levels at an input terminal, the circuit comprising:

    first power source terminal means for supplying a first power source voltage (VDD);

    second power source terminal means for supplying a second power source voltage (VCC) which is higher than the first power source voltage (VDD);

third power source terminal means for supplying a reference voltage (VSS);

voltage level shift means (23, 24, 25) responsive to a change in level of the input signal (IN) in the first direction to provide a level shifted signal having a level substantially equal to the level of the second power source voltage (VCC);

pull-up circuit means including first transistor means (27) responsive to the signal provided by the voltage level shift means (23, 24, 25) to raise the level of the output signal (OUT) substantially to the second power source voltage level (VCC), and

pull-down circuit means (26,31,32) responsive to a change in level of the input signal (IN) in the second direction to lower the level of the output signal (OUT) substantially to the reference voltage level (VSS),

characterised in that the pull-up circuit means includes second transistor means (30) for outputting the second power source voltage (VCC) to the output terminal, and first delay means (29) for delaying the output from the second transistor means (30) for a predetermined time with respect to the output from the first transistor means (27).

2. An output circuit according to claim 1, characterised in that the first delay means includes a first resistor (29).

3. An output circuit according to claim 1 or 2, characterised in that the pull-down circuit means (26, 31, 32) includes third and fourth transistor means (26, 32) for outputting the reference voltage (VSS) to the output terminal, and second delay means (31) for delaying the output of the fourth transistor means (32) for a predetermined time with respect to the output of the third transistor means (26).

4. An output circuit according to claim 3, characterised in that the second delay means includes a second resistor (31).

5. An output circuit according to any one of claims 1 to 4, characterised in that the voltage level shift means includes an inverter circuit (23) responsive to the first power source voltage (VDD) and the reference voltage (VSS).

6. An output circuit according to claim 5, characterised in that the inverter circuit is CMOS inverter circuit (23).

7. An output circuit according to claim 6, characterised in that the voltage level shift means includes a MOS transistor (25) having a gate electrode supplied with the output signal from the CMOS inverter circuit (23) and a multi-collector bipolar transistor (24) responsive to the output of the MOS transistor (25) and the second power source voltage (VCC).

8. An output circuit according to claim 3, characterised in that the first transistor means includes a first MOS transistor (27) having a gate electrode supplied with the level shifted signal, a drain electrode supplied with the second power source voltage (VCC) and a source electrode connected to the output terminal, the second transistor means includes a second MOS transistor (30) having a gate electrode supplied with the level shifted signal (VCC) through the first delay means (29), a drain electrode supplied with the second power source voltage (VCC) and a source electrode connected to the output terminal (OUT), the third transistor means includes a third MOS transistor (26) having a gate electrode supplied with the input signal (IN), a drain electrode connected to the gate electrode of the first and the second MOS transistors (27, 30) and a source electrode supplied with the reference voltage (VSS), and the fourth transistor means includes a fourth MOS transistor (32) having a gate electrode supplied with the input signal (IN) through the second delay means (31), a drain electrode connected to the gate electrodes of the first and the second MOS transistors (27, 30) and a source electrode supplied with the reference voltage (VSS).

**Patentansprüche**

1. Ausgangsschaltung für die Ausgabe eines Ausgangssignals (OUT) mit einem ersten und einem zweiten vorgegebenen Pegel (VCC, VSS) an einem Ausgangsanschluß als Antwort auf ein Eingangssignal (IN), das in einer ersten und einer zweiten Richtung zwischen einem hohen und einem niedrigen Pegel an einem Eingangsanschluß wechselt, welche Schaltung aufweist:

einen ersten Stromversorgungsanschluß zur Zuführung einer ersten Speisespannung (VDD);

einen zweiten Stromversorgungsanschluß zur Zuführung einer zweiten Speisespannung (VCC), die höher ist als die erste Speisespannung (VDD); einen dritten Stromversorgungsanschluß zur Zuführung einer Bezugsspannung (VSS);

eine Spannungspegel-Verschiebungseinrichtung (23, 24, 25), die als Antwort auf eine Pegeländerung des Eingangssignals (IN) in der ersten Richtung ein pegelverschobenes Signal liefert, dessen Pegel im wesentlichen gleich dem Pegel der zweiten Speisespannung (VCC) ist;

eine Pegelerhöhungsschaltung mit einer ersten Transistoreinrichtung (27), die als Antwort auf das von der Spannungspegel-Verschiebungseinrichtung (23, 24, 25) angelegte Signal den Pegel des Ausgangssignals (OUT) im wesentlichen auf den Pegel der zweiten Speisespannung (VCC) erhöht;

eine Pegelerniedrigungsschaltung (26, 31, 32), die als Antwort auf eine Pegeländerung des Eingangssignals (IN) in der zweiten Richtung den Pegel des Ausgangssignals (OUT) im wesentlichen auf den Bezugsspannungspegel (VSS) erniedrigt,

dadurch gekennzeichnet, daß die Pegelerhöhungsschaltung eine zweite Transistoreinrichtung (30) für die Ausgabe der zweiten Speisespannung (VCC) zum Ausgangsanschluß sowie eine erste Verzögerungseinrichtung (29) aufweist, um das Ausgangssignal der zweiten Transistoreinrichtung (30) gegenüber dem Ausgangssignal der ersten Transistoreinrichtung (27) um eine vorgegebene Zeit zu verzögern.

2. Ausgangsschaltung nach Anspruch 1, dadurch gekennzeichnet, daß die erste Verzögerungseinrichtung einen ersten Widerstand (29) einschließt.

3. Ausgangsschaltung nach Anspruch 1 oder 2, dadurch gekennzeichnet, daß die Pegelerniedrigungsschaltung (26, 31, 32) eine dritte und eine vierte Transistoreinrichtung (26, 32) für die Ausgabe der Bezugsspannung (VSS) zum Ausgangsanschluß sowie eine zweite Verzögerungseinrichtung (31) einschließt, um das Ausgangssignal der vierten Transistoreinrichtung (32) gegenüber dem Ausgangssignal der dritten Transistoreinrichtung (26) um eine vorgegebene Zeit zu verzögern.

4. Ausgangsschaltung nach Anspruch 3, dadurch gekennzeichnet, daß die zweite Verzögerungseinrichtung einen zweiten Widerstand (31) einschließt.

5. Ausgangsschaltung nach einem der Ansprüche 1 bis 4, dadurch gekennzeichnet, daß die Spannungspegel-Verschiebungseinrichtung eine Inverterschaltung (23) einschließt, die auf die erste Speisespannung (VDD) und die Bezugsspannung (VSS) anspricht.

6. Ausgangsschaltung nach Anspruch 5, dadurch gekennzeichnet, daß die Inverterschaltung eine CMOS-Inverterschaltung (23) ist.

7. Ausgangsschaltung nach Anspruch 6, dadurch gekennzeichnet, daß die Spannungspegel-Verschiebungseinrichtung einen MOS-Transistor (25) mit einer Gate-Elektrode, der das Ausgangssignal von der CMOS-Inverterschaltung (23) zugeführt wird, sowie einen Bipolartransistor mit mehreren Kollektoren (24) einschließt, der auf das Ausgangssignal des MOS-Transistors (25) und die zweite Speisespannung (VCC) anspricht.

8. Ausgangsschaltung nach Anspruch 3, dadurch gekennzeichnet, daß die erste Transistoreinrichtung einen ersten MOS-Transistor (27) mit einer Gate-Elektrode, der das pegelverschobene Signal zugeführt wird, einer mit der zweiten Speisespannung (VCC) gespeisten Drain-Elektrode und einer mit dem Ausgangsanschluß verbundenen Source-Elektrode einschließt, daß die zweite Transistoreinrichtung einen zweiten MOS-Transistor (30) mit einer Gate-Elektrode, der über die erste Verzögerungseinrichtung (29) das pegelverschobene Signal (VCC) zugeführt wird, einer mit der zweiten Speisespannung (VCC) gespeisten Drain-Elektrode und einer mit dem Ausgangsanschluß (OUT) verbundenen Source-Elektrode einschließt, daß die dritte Transistoreinrichtung einen dritten MOS-Transistor (26) mit einer Gate-Elektrode, der das Eingangssignal (IN) zugeführt wird, einer mit den Gate-Elektroden des ersten und des zweiten MOS-Transistors (27, 30) verbundenen Drain-Elektrode und einer mit der Bezugsspannung (VSS) gespeisten Source-Elektrode einschließt, und daß die vierte Transistoreinrichtung einen vierten MOS-Transistor (32) mit einer Gate-Elektrode, der über die zweite Verzögerungseinrichtung (31) das Eingangssignal (IN) zugeführt wird, einer mit den Gate-Elektroden des ersten und des zweiten MOS-Transistors (27, 30) verbundenen Drain-Elektrode und einer mit der Bezugsspannung (VSS) gespeisten Source-Elektrode einschließt.

**Revendications**

1. Circuit de sortie pour émettre en sortie au niveau d'une borne de sortie un signal de sortie (OUT) à des premier et second niveaux prédéterminés (VCC, VSS) en réponse à un signal d'entrée (IN) présentant de façon alternée des premier et second sens entre des niveaux haut et bas au niveau d'une borne d'entrée, le circuit comprenant:

un premier moyen de borne d'alimentation pour appliquer une première tension d'alimentation (VDD);

un second moyen de borne d'alimentation pour appliquer une seconde tension d'alimentation (VCC) qui est supérieure à la première tension d'alimentation (VDD);

un troisième moyen de borne d'alimentation pour appliquer une tension de référence (VSS);

un moyen de décalage de niveau de tension (23, 24, 25) sensible à une variation du niveau du signal d'entrée (IN) suivant le premier sens pour produire un signal décalé en niveau présentant un niveau sensiblement égal au niveau de la seconde tension d'alimentation (VCC);

un moyen de circuit de tirage vers le haut incluant un premier moyen de transistor (27) sensible au signal produit par le moyen de décalage de niveau de tension (23, 24, 25) afin d'augmenter le niveau du signal de sortie (OUT) sensiblement jusqu'au second niveau de tension d'alimentation (VCC); et

un moyen de circuit de tirage vers le bas (26, 31, 32) sensible à une variation du niveau du signal d'entrée (IN) suivant le second sens pour abaisser le niveau du signal de sortie (OUT) sensiblement jusqu'au niveau de tension de référence (VSS),

caractérisé en ce que le moyen de circuit de tirage vers le haut inclut un second moyen de transistor (30) pour émettre en sortie la seconde tension d'alimentation (VCC) sur la borne de sortie et un premier moyen de retard (29) pour retarder la sortie provenant du second moyen de transistor (30) d'une durée prédéterminée par rapport à la sortie provenant du premier moyen de transistor (27).

2. Circuit de sortie selon la revendication 1, caractérisé en ce que le premier moyen de retard inclut une première résistance (29).

3. Circuit de sortie selon la revendication 1 ou 2, caractérisé en ce que le moyen de circuit de tirage vers le bas (26, 31, 32) inclut des troisième et quatrième moyens de transistor (26, 32) pour émettre en sortie la tension de référence (VSS) sur la borne de sortie et un second moyen de retard (31) pour retarder la sortie du quatrième moyen de transistor (32) d'une durée prédéterminée par rapport à la sortie du troisième moyen de transistor (26).

4. Circuit de sortie selon la revendication 3, caractérisé en ce que le second moyen de retard inclut une seconde résistance (31).

5. Circuit de sortie selon l'une quelconque des revendications 1 à 4, caractérisé en ce que le moyen de décalage de niveau de tension inclut un circuit inverseur (23) sensible à la première tension d'alimentation (VDD) et à la tension de référence (VSS).

6. Circuit de sortie selon la revendication 5, caractérisé en ce que le circuit inverseur est un circuit inverseur CMOS (23).

7. Circuit de sortie selon la revendication 6, caractérisé en ce que le moyen de décalage de niveau de tension inclut un transistor MOS (25) comportant une électrode de grille qui se voit appliquer le signal de sortie provenant du circuit inverseur CMOS (23) et un transistor bipolaire à multiples collecteurs (24) sensible à la sortie du transistor MOS (25) et à la seconde tension d'alimentation (VCC).

8. Circuit de sortie selon la revendication 3, caractérisé en ce que le premier moyen de transistor inclut un premier transistor MOS (27) comportant une électrode de grille qui se voit appliquer le signal décalé en niveau, une électrode de drain qui se voit appliquer la seconde tension d'alimentation (VCC) et une électrode de source connectée à la borne de sortie, le second moyen de transistor inclut un second transistor MOS (30) comportant une électrode de grille qui se voit appliquer le signal décalé en niveau (VCC) par l'intermédiaire du premier moyen de retard (29), une électrode de drain qui se voit appliquer la seconde tension d'alimentation (VCC) et une électrode de source connectée à la borne de sortie (OUT), le troisième moyen de transistor inclut un troisième transistor MOS (26) comportant une électrode de grille qui se voit appliquer le signal d'entrée (IN), une électrode de drain connectée à l'électrode de grille des premier et second transistors MOS (27, 30) et une électrode de source qui se voit appliquer la tension de référence (VSS) et le quatrième moyen de transistor inclut un quatrième transistor MOS (32) comportant une électrode de grille qui se voit appliquer le signal d'entrée (IN) par l'intermédiaire du second moyen de retard (31), une électrode de drain connectée aux électrodes de grille des premier et second transistors MOS (27, 30) et une électrode de source qui se voit appliquer la tension de référence (VSS).

F I G. 1

P R I O R   A R T

F I G. 2

8

FIG. 3